# EUROPEAN PATENT APPLICATION

(11) **EP 1 122 779 A2**
(43) Date of publication of application: **08.08.2001**
(21) Application number: 01300605.1
(22) Date of filing: 24.01.2001
(51) Int. Cl.: H01L 23/373

(54) **Carbon fiber reinforced resin heat radiation fin mounted on a substrate**

(30) Priority: 31.01.2000 JP 2000021914
(71) Applicant: SHINKO ELECTRIC INDUSTRIES CO. LTD., Nagano-shi, Nagano 380-0921 (JP)
(72) Inventor: Murayama, Kei, c/o Shinko Electric Ind. Co., Ltd., Nagano-shi, Nagano 380-0921 (JP)
(74) Representative: Whalley, Kevin

(57) **Abstract**

A heat radiation fin (10) comprises a substrate (11) having a high thermal conductivity and a plurality of heat radiation plates (12). The heat radiation plates (12) are arranged upright on the substrate (11) with predetermined intervals therebetween. Each of the heat radiation plates (12) is formed of a heat-resistant resin containing carbon fibers.

## Description

### BACKGROUND OF THE INVENTION

### 1. Field of the Invention

The present invention generally relates to a heat radiation fin, a manufacturing method thereof and a semiconductor device and, more particularly, to a technology which can lighten a semiconductor device comprising a package structure, such as a BGA (Ball Grid Array) or a PGA (Pin Grid Array), and a heat radiation fin.

### 2. Description of the Related Art

Recently, as a semiconductor element (LSI chip) mounted on a package of a semiconductor device has been improved to present high performance, the semiconductor device is required to operate at high-speed. However, as the speed increases, a larger heat is produced during a circuit operation, causing an inconvenience of decreased reliability of the circuit operation.

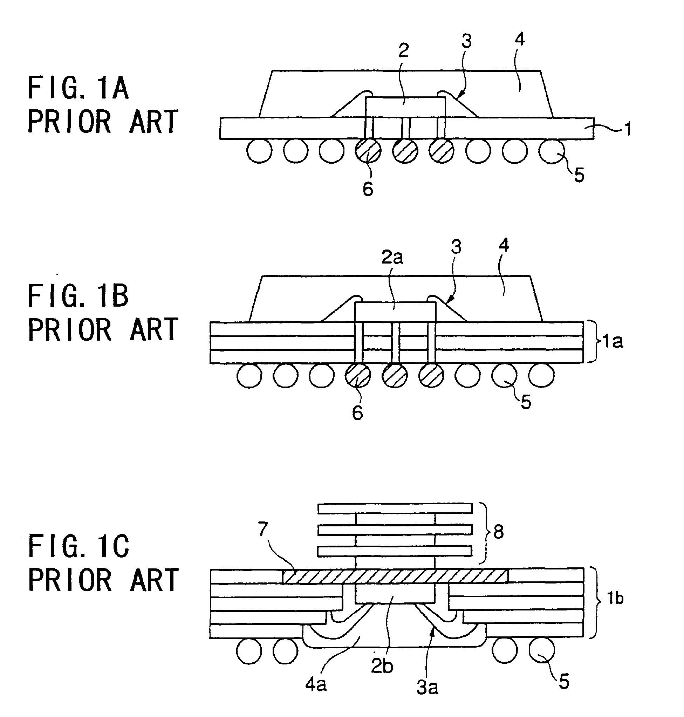

As a countermeasure to this, a typical semiconductor device according to a conventional technology has a heat radiation structure to emit a heat generated from the semiconductor chip to the exterior of the package. FIG.1A to FIG.1C show examples of semiconductor devices having this structure.

FIG.1A is an illustration of a structure of a semiconductor device comprising: a plastic BGA (package) having an interconnection substrate formed of a resin (plastic) and a metal bump formed thereon as an external connection terminal; and a semiconductor chip, of not remarkably high performance and of a currently mass-produced type, mounted on the plastic BGA. FIG.1B is an illustration of a structure of a semiconductor device comprising: a plastic BGA (package) having an interconnection substrate formed of a resin (plastic) and a metal bump formed thereon as an external connection terminal; and a semiconductor chip, faster and more power-consuming than the semiconductor chip shown in FIG.1A, mounted on the plastic BGA. FIG.1C is an illustration of a structure of a semiconductor device comprising: a plastic BGA (package) having an interconnection substrate formed of a resin (plastic) and a metal bump formed thereon as an external connection terminal; and a semiconductor chip, of even higher performance than the semiconductor chip shown in FIG.1B, mounted on the plastic BGA.

In FIG.1A, a semiconductor chip 2 is mounted on one surface of an interconnection substrate 1 so that a surface of the semiconductor chip 2 opposite to a side where an electrode terminal of the semiconductor chip 2 is formed is bonded on the surface of the interconnection substrate 1. The electrode terminal of the semiconductor chip 2 is electrically connected to an interconnection pattern formed on the interconnection substrate 1 in a predetermined manner through a bonding wire 3. A sealing resin 4 covers and seals the semiconductor chip 2 and the bonding wire 3. On the other surface of the interconnection substrate 1 is formed a solder bump 5 which is used as an external connection terminal for the semiconductor chip 2. Also, on the other surface of the interconnection substrate 1 is formed a solder bump 6 which is used as a terminal to radiate heat generated from the semiconductor chip 2. The heat radiation terminal (solder bump 6) penetrates through the interconnection substrate 1 and is thermally connected to the semiconductor chip 2. Likewise, though not particularly shown in the figure, the external connection terminal (solder bump 5) penetrates through the interconnection substrate 1 and is electrically connected to the interconnection pattern formed on the interconnection substrate 1.

With respect to the semiconductor device shown in FIG.1A, the interconnection pattern may be formed on both surfaces of the interconnection substrate 1, providing a two-layer structure. However, such a two-layer structure is still not adequate for a semiconductor chip requiring a further high-speed operation to be mounted thereon.

In the semiconductor device shown in FIG.1B, to adapt to such a high-speed operation, an interconnection substrate la is constructed to have a four-layer structure which may achieve an inhibition of a switching noise during a circuit operation in a semiconductor chip 2a and a decrease in thermal resistance. This structure also has the heat radiation terminal (solder bump 6) as a heat radiation structure to radiate heat generated from the semiconductor chip 2a.

In the semiconductor device shown in FIG.1C, to adapt to even higher performance, an interconnection substrate 1b is constructed to have a six-layer structure. A heat spreader 7, which is a highly thermally conductive metal plate, such as copper (Cu) or aluminum (Al), is bonded on the backside (the opposite surface to where an electrode terminal of a semiconductor chip 2b is formed) of the semiconductor chip 2b placed inside a cavity formed in a middle part of the interconnection substrate 1b so as to further reduce the thermal resistance. Still more, a heat sink 8 formed of a material such as a metal or a ceramic, is mounted on the heat spreader 7 so as to enhance a heat radiation effect. In the semiconductor device shown in FIG.1C, heat radiation fins composing the heat sink 8 protrude in directions parallel to a surface of the interconnection substrate 1b. The electrode terminal of the semiconductor chip 2b bonded to the heat spreader 7 is electrically connected to an interconnection pattern formed on each layer of the interconnection substrate 1b through a bonding wire 3a. A sealing resin 4a covers and seals the semiconductor chip 2b and the bonding wire 3a.

The above-mentioned semiconductor devices according to the conventional technology have disadvantages. For example, in the structures shown in FIG.1A and FIG.1B, the heat generated from the semiconductor chip 2 or 2a is only radiated from the underside of the package (interconnection substrate 1 or interconnection substrate la) through a limited number of the heat radiation terminals (solder bumps 6). Thus, these structures shown in FIG.1A and FIG.1B are not sufficient in terms of heat radiation effect.

To solve this problem, the number of the heat radiation terminals 6 may be increased, as a countermeasure. However, since the package is constructed in a specified size, the increase in number of the heat radiation terminals 6 leads to a relative decrease in number of the external connection terminals (solder bumps 5), which poses more serious problems on the semiconductor devices. Consequentially, the number of the heat radiation terminals 6 is limited, undermining this countermeasure.

On the other hand, in the structure shown in FIG.1C, since the heat radiation structures (heat spreader 7 and heat sink 8) are thermally connected with the semiconductor chip 2b, the heat generated from the semiconductor chip 2b is effectively radiated from the upper side of the package (interconnection substrate 1b) through these heat radiation structures 7 and 8. The heat generated from the semiconductor chip 2b is also radiated from the underside of the package (interconnection substrate 1b) through the sealing resin 4a and air between the sealing resin 4a and a mounting substrate, such as a motherboard (not shown in the figure). Therefore, this structure shown in FIG.1C is advantageous in terms of the heat radiation effect, compared to the structures shown in FIG.1A and FIG.1B.

However, this structure shown in FIG.1C also has a disadvantage. That is, since a metal plate, such as copper (Cu) or aluminum (Al), or a material such as a ceramic is used as the heat radiation structures (heat spreader 7 and heat sink 8), the whole package becomes relatively heavy. Especially when considering the recently increasing needs toward lightening of the semiconductor packages, this disadvantage still has to be improved.

### SUMMARY OF THE INVENTION

It is a general object of the present invention to provide an improved and useful heat radiation fin, a manufacturing method thereof and a semiconductor device in which the above-mentioned problems are eliminated.

A more specific object of the present invention is to provide a heat radiation fin and a semiconductor device which fin and device can be lightened while maintaining an expected heat radiation effect, and a manufacturing method thereof.

In order to achieve the above-mentioned objects, there is provided according to one aspect of the present invention a heat radiation fin comprising:
a substrate having a high thermal conductivity; and
a plurality of heat radiation plates arranged upright on the substrate with predetermined intervals therebetween,
wherein each of the heat radiation plates is formed of a heat-resistant resin containing carbon fibers.

According to the present invention, the heat-resistant molded resin containing carbon fibers is used as the plurality of the heat radiation plates arranged upright on the substrate. Therefore, while the expected heat radiation effect is maintained, the semiconductor device can be lightened, compared to the conventional technology which uses such a material as a metal plate, such as a Cu or Al plate, as a heat radiation structure.

Other objects, features and advantages of the present invention will become more apparent from the following detailed description when read in conjunction with the accompanying drawings.

### BRIEF DESCRIPTION OF THE DRAWINGS

FIG.1A is an illustration for explaining problems of a semiconductor device comprising a heat radiation structure according to a conventional technology;
FIG. 1B is an illustration for explaining problems of another semiconductor device comprising a heat radiation structure according to the conventional technology;
FIG.1C is an illustration for explaining problems of still another semiconductor device comprising a heat radiation structure according to the conventional technology;
FIG.2 is a perspective view of a structure of a heat radiation fin according to an embodiment of the present invention;
FIG.3A is a plan view of a structure of carbon fibers of a CFRP (a heat radiation plate) shown in FIG.2;
FIG.3B is a cross-sectional view of the structure taken along a line III-III in FIG.3A;
FIG.4 is a cross-sectional view showing steps of a manufacturing method of the heat radiation fin shown in FIG.2;
FIG.5 is a cross-sectional view showing steps of another manufacturing method of the heat radiation fin shown in FIG.2;
FIG.6 is a cross-sectional view of a structure of a semiconductor device comprising the heat radiation fin shown in FIG.2; and
FIG.7 is a cross-sectional view of a structure of another semiconductor device comprising the heat radiation fin shown in FIG.2.

### DETAILED DESCRIPTION OF THE PREFERRED EMBODIMENTS

A description will now be given, with reference to the drawings, of embodiments according to the present invention.

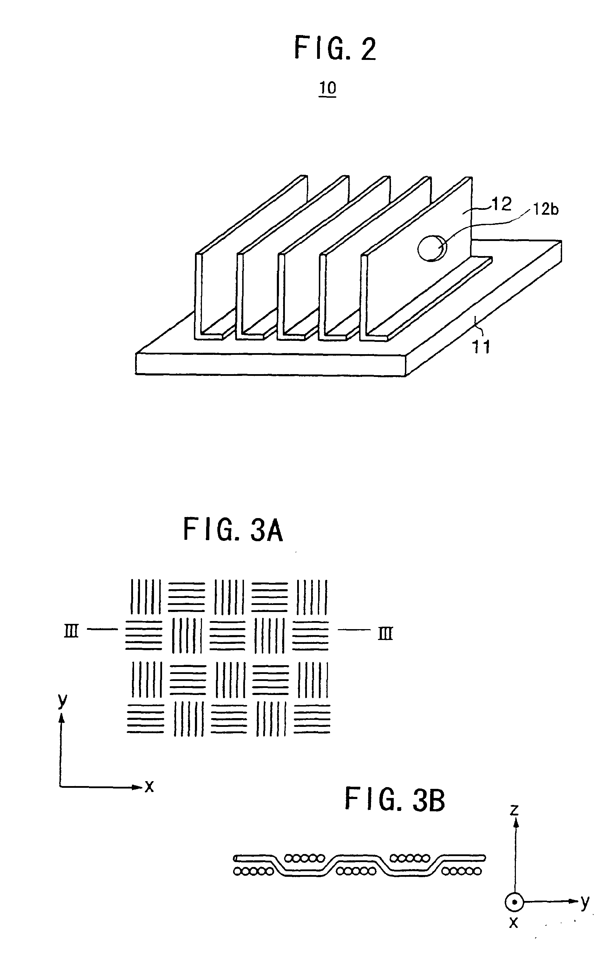

FIG.2 is a perspective view of a structure of a heat radiation fin according to an embodiment of the present invention.

The heat radiation fin 10 according to the present embodiment is characterized in that a plurality (five in FIG.2) of heat radiation plates 12 in the form of a sheet are arranged to stand in an array on a substrate 11, having a relatively good thermal conductivity, so that a surface of each of the heat radiation plates 12 faces a surface of another of the heat radiation plates 12 with an interval in between. Each of the heat radiation plates 12 is formed of a heat-resistant molded resin containing carbon fibers. Such a resin reinforced with carbon fibers is referred to as a CFRP (Carbon Fiber Reinforced Plastic) hereinafter.

In the present embodiment, when each of the heat radiation plates 12 is arranged to stand on the substrate 11, a portion of each of the heat radiation plates 12 on one end is bent so that each of the heat radiation plates 12 has an L-shape. Then the shorter bent portion is bonded to the substrate 11.

Used as the heat radiation plate 12 is an adhesive sheet hardened through heating and pressurizing processes, which processes harden a semihard adhesive sheet in a B-stage (i.e., a CFRP in the form of a prepreg) formed by impregnating a reinforcing material, such as a PAN-based carbon fiber based on a polyacrylonitrile (PAN) or a pitchbased carbon fiber based on a pitch obtained in distilling such a material as a coal tar, with a thermosetting resin such as an epoxy resin. It should be noted that FIG.2 to FIG.7 show the heat radiation plates 12 (the molded and hardened CFRP) as having an emphatically exaggerated thickness.

On the other hand, a metal plate such as a Cu or an Al plate can be used as the substrate 11 having a relatively good thermal conductivity. Alternatively, the same material as the heat radiation plate 12 (i.e., the molded and hardened CFRP) can be used as the substrate 11. As mentioned hereinafter, when the heat radiation fin 10 according to the present embodiment is expected to exert a further heat radiation effect, the metal plate is preferred to be used as the substrate 11. On the other hand, when the heat radiation fin 10 is expected to be lightened further, the CFRP is preferred to be used.

The heat radiation plate 12 in the form of a sheet (i.e., the molded and hardened CFRP) is devised to radiate heat effectively. FIG.3A and FIG.3B show an example of this.

FIG.3A is a plan view of a structure of carbon fibers of the CFRP (the heat radiation plate 12). FIG.3B is a cross-sectional view of the structure taken along a line III-III in FIG.3A.

A reinforcing material of the CFRP (the heat radiation plate 12) is formed by weaving carbon fibers so that the carbon fibers extend in directions x and y, as shown in FIG.3A and FIG.3B. The directions x and y are parallel to a surface of the heat radiation plate 12 arranged to stand on the substrate 11. In a case of using, for example, the PAN-based carbon fiber as the carbon fiber, a coefficient of thermal conductivity in the directions x and y is 40 to 45 W/m·K. On the other hand, a coefficient of thermal conductivity in a direction z perpendicular to the directions x and y (i.e., a direction parallel to a surface of the substrate 11) is merely 1 to 2 W/m · K. That is, the coefficient of thermal conductivity in the directions x and y, in which the carbon fibers extend, is relatively large. Therefore, by weaving the carbon fibers so that the carbon fibers extend in the directions x and y as shown in FIG.3A and FIG.3B, the heat radiation plate 12 can radiate heat effectively.

It should be noted that, although the carbon fibers are woven so that the carbon fibers extend in both of the directions x and y in FIG.3A and FIG.3B, the carbon fibers may be woven so that the carbon fibers extend in either of the directions x or y. Further, the carbon fibers may be woven so that the carbon fibers extend in an arbitrary direction in a plane x and y. However, to achieve further effective heat radiation, it is preferred that the carbon fibers be woven so that the carbon fibers extend only in directions perpendicular to a surface of the substrate 11.

The heat radiation fin 10 according to the present embodiment is mounted on various types of semiconductor devices when used, as specifically explained hereinafter. When mounted and used, since the heat radiation fin 10 according to the present embodiment comprises a plurality of CFRPs in the form of a sheet used as the heat radiation plate 12 to radiate heat generated from a semiconductor device (specifically, a semiconductor chip), while the expected heat radiation effect is maintained, the heat radiation fin 10 can be largely lightened, compared to the conventional technology shown in FIG.1C which uses such a material as a metal plate, such as a Cu or Al plate, as a heat radiation structure.

In addition, since the carbon fibers of the CFRP (the heat radiation plate 12) are woven so that the carbon fibers extend in the directions x and y (i.e., the directions parallel to a surface of the heat radiation plate 12) in which the coefficient of thermal conductivity is relatively large, the heat can be effectively radiated.

Although the heat radiation fin 10 according to the embodiment shown in FIG.2 comprises a plurality of the heat radiation plates 12 in the form of a sheet arranged to stand in an array on the substrate 11 so that a surface of each of the heat radiation plates 12 faces a surface of another of the heat radiation plates 12 with an interval in between, arrangements of the heat radiation plates 12 are not limited to this embodiment. As apparent from the essence of the present invention, a plurality of the heat radiation plates 12 in the form of a sheet do not necessarily have to be arranged to stand in an array so that a surface of each of the heat radiation plates 12 faces a surface of another of the heat radiation plates 12. A plurality of the heat radiation plates 12 in the form of a sheet only have to be arranged to stand on the substrate 11 with an interval in between.

A shape of the heat radiation plate 12 is not limited to this embodiment, either. For example, each of the heat radiation plates 12 may be as narrow as possible in width so that a plurality of the heat radiation plates 12 have a form of strips or needles. Alternatively, at least one of the heat radiation plates 12 may have an opening 12b so as to enhance the heat radiation effect further.

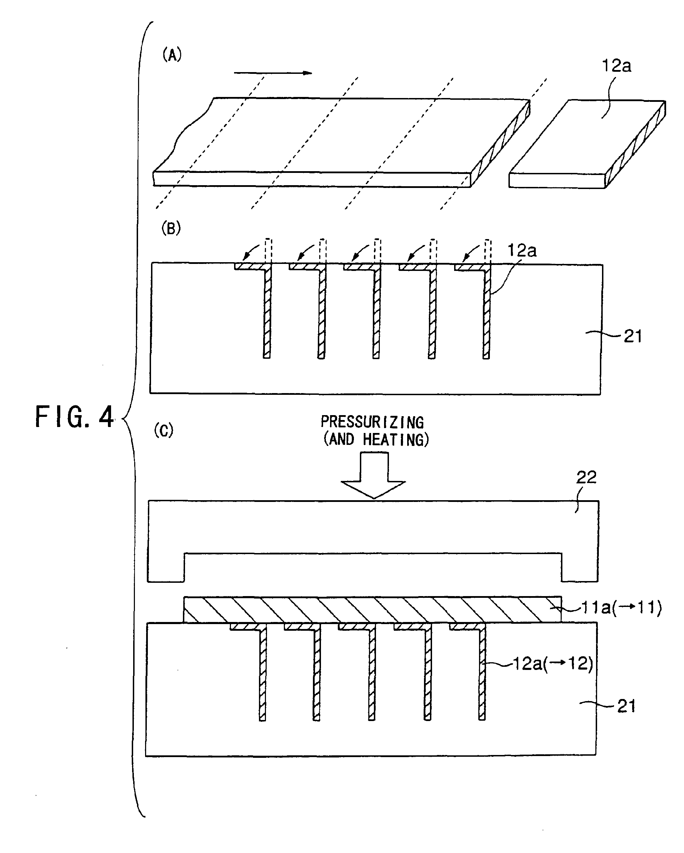

Next, a description will be given, with reference to FIG.4, of an example of manufacturing the heat radiation fin 10 according to the present embodiment.

In the first step, shown in FIG.4-(A), a predetermined number of CFRPs 12a in the form of a prepreg, each having a rectangular shape and a predetermined size (for example, 20 mm X 15 mm), are prepared. A thickness of each of the CFRPs 12a in the form of a prepreg is selected to be, for example, approximately 100 *µ*m.

Each of the CFRPs 12a is formed, for example, by cutting a CFRP in predetermined length units, as shown by broken lines in FIG.4-(A), in the course of unrolling a roll (not shown in the figure) of the CFRP rolled up beforehand in a predetermined width and carrying in the unrolled CFRP, as shown by an arrow in FIG.4-(A).

A reinforcing material of the CFRP 12a is formed by weaving carbon fibers so that the carbon fibers extend in a plurality of directions parallel to a surface of the CFRP (the directions x and y shown in FIG.3A and FIG.3B).

In the next step, shown in FIG.4-(B), by using a holding device 21, the CFRPs 12a each in the form of a prepreg are arranged in an array so that a surface of each of the CFRPs 12a faces a surface of another of the CFRPs 12a with an interval in between. Thereafter, an end portion of each of the CFRPs 12a is bent, as shown by arrows in FIG.4-(B), so that each of the CFRPs 12a has an L-shape.

To perform this step, the holding device 21 comprises a plurality of L-shaped slots (inversely L-shaped in FIG.4), formed at predetermined intervals, in order to hold the CFRPs 12a. Each of the slots is selected to be, for example, 100 *µ*m in width, 10 mm in depth and 20 mm in length, approximately. The interval is selected from the range of, for example, 2 to 5 mm. Therefore, when a CFRP 12a having a size of 20 mm × 15 mm is put into each of the slots of the holding device 21, a portion (20 mm X 5 mm) of the CFRP 12a protrudes from an upper surface of the holding device 21. Bending this shorter portion, for example, by hand, provides the L-shaped CFRPs 12a arranged at the predetermined intervals, as shown in FIG.4-(B).

In the final step, shown in FIG.4-(C), by using the holding device 21 holding the L-shaped CFRPs 12a and a mold 22 having a shape corresponding to an outline as seen from the side of the substrate 11, each of the CFRPs in the form of a prepreg is molded and bonded to the substrate 11.

That is, a CFRP 11a in the form of a prepreg to form the substrate 11 is placed upon the shorter bent portions of the L-shaped CFRPs 12a. Then, the L-shaped CFRPs 12a and the CFRP 11a are pressurized from above as shown by an arrow in FIG.4-(C) by using the mold 22, while being heated at a temperature of approximately 150°C. Thereby, the L-shaped CFRPs 12a and the CFRP 11a (the substrate 11) are molded and hardened, and each of the L-shaped CFRPs 12a is bonded to the substrate 11. It should be noted that the CFRP lla (the substrate 11) is selected to be, for example, 200-*µ*m thick approximately.

Thereafter, the substrate 11 bonded to the molded and hardened CFRPs (the heat radiation plates 12 in the form of a sheet) is retrieved from the holding device 21 and the mold 22. This finishes the manufacturing of the heat radiation fin 10 (shown in FIG.2) according to the present embodiment.

In the manufacturing method show in FIG.4, a predetermined number of the CFRPs 12a in the form of a prepreg are arranged in the holding device 21 and the end portion of each of the CFRPs 12a is bent so that each of the CFRPs 12a has an L-shape. Thereafter, the CFRP 11a in the form of a prepreg to form the substrate 11 is placed upon the shorter bent portions of the L-shaped CFRPs 12a. Then the L-shaped CFRPs 12a and the CFRP lla are molded and hardened by heating and pressurizing, and each of the L-shaped CFRPs 12a (the heat radiation plates 12) is bonded to the substrate 11, finishing the manufacturing of the heat radiation fin 10. However, a manufacturing method of the heat radiation fin 10 is not limited to this embodiment.

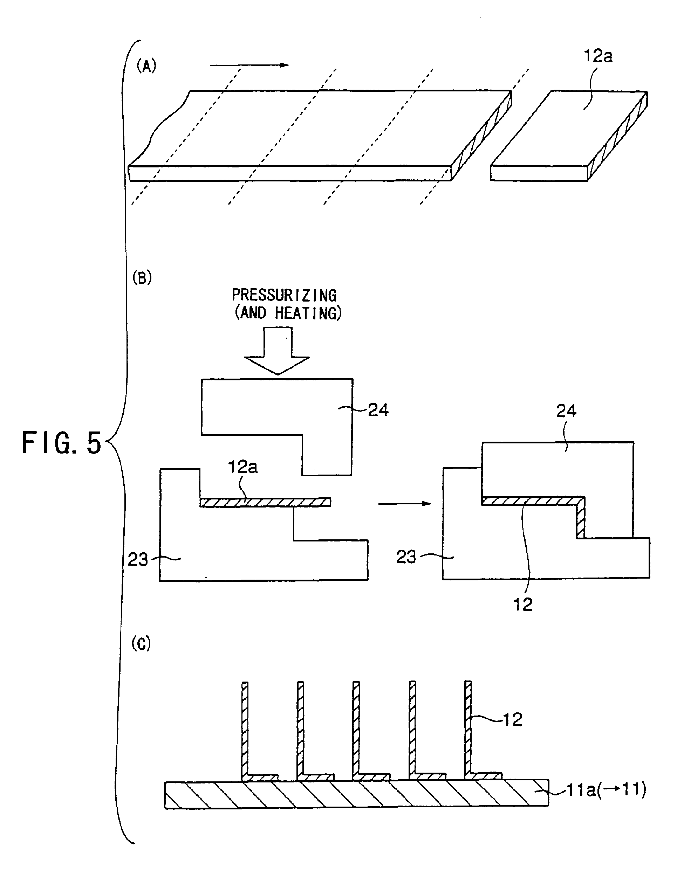

For example, after each of the CFRPs 12a is molded and hardened to an L-shape as seen from the side, each of the CFRPs 12a may be mounted on the substrate 11 (the CFRP lla in the form of a prepreg) and then bonded to the substrate 11 through heating and pressurizing. FIG.5 shows an example of this manufacturing method.

In the first step, shown in FIG.5-(A), a predetermined number of CFRPs 12a in the form of a prepreg, each having a rectangular shape and a predetermined size, are prepared, as the step shown in FIG.4-(A).

In the next step shown in FIG.5-(B), the CFRP 12a in the form of a prepreg is molded by using an under mold 23 and an upper mold 24 having a shape corresponding to an outline (L-shape) of the heat radiation plate 12 as seen from the side. That is, the CFRP 12a is placed on the under mold 23 and pressurized from above as shown by an arrow in FIG.5-(B) by using the upper mold 24, while being heated at a temperature of approximately 150°C. Thereby, the CFRP 12a is molded and hardened in the L-shape. Thereafter, the molded and hardened CFRP 12a (the heat radiation plate 12) is retrieved from the under mold 23 and the upper mold 24.

In the final step shown in FIG.5-(C), each of the heat radiation plates 12 is mounted in an array on a CFRP 11a in the form of a prepreg forming the substrate 11 so that the shorter bent portion of each of the L-shaped heat radiation plates 12 faces downward and that a surface of the longer portion of each of the heat radiation plates 12 faces a surface of the longer portion of another of the heat radiation plates 12 with an interval in between. Then, the CFRP 11a is hardened and molded by heating and pressurizing by using devices, such as a holding device and a mold, (not shown in the figures), and each of the heat radiation plates 12 is bonded to the substrate 11.

In the manufacturing method shown in FIG.5, after each of the CFRPs 12a in the form of a prepreg is molded and hardened into an L-shape, each of the heat radiation plates 12 (the CFRPs 12a) is mounted and bonded on the substrate 11 (the CFRP lla in the form of a prepreg). However, each of the CFRPs 12a in the form of a prepreg does not necessarily have to be molded and hardened into the L-shape. For example, though not specifically shown in the figures, each of the CFRPs 12a may be molded and hardened in the form of a flat sheet as it original is (that is, not molded into the L-shape). Then, each of the hardened CFRPs (the heat radiation plates) in the form of a flat sheet is mounted on the substrate 11 (the CFRP lla in the form of a prepreg) in an array with an interval in between by thrusting an end portion of each of the heat radiation plates into the substrate 11. Then, each of the heat radiation plates may be bonded to the substrate 11 by heating and pressurizing.

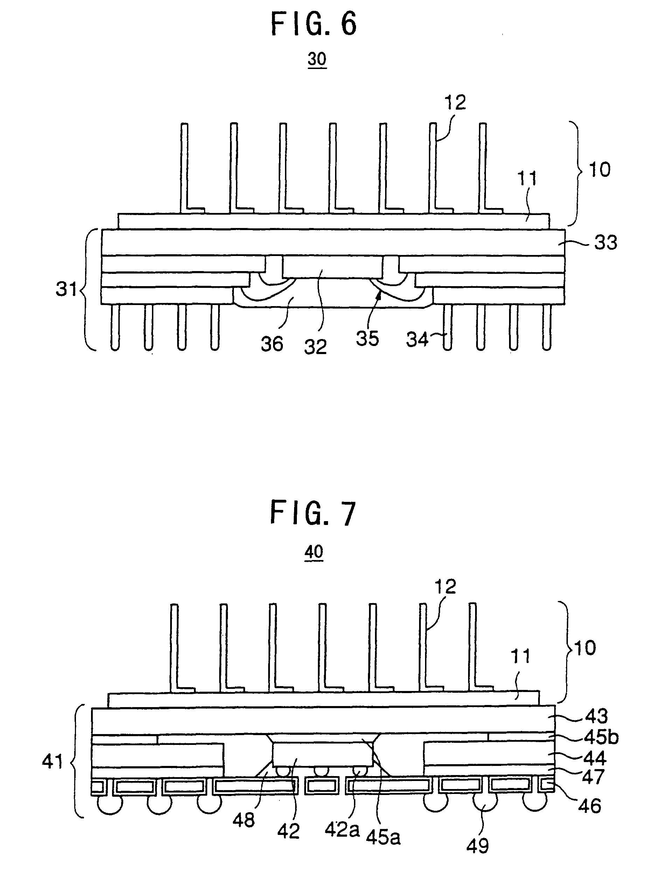

The heat radiation fin 10 according to the present embodiment can be preferably mounted on various types of semiconductor devices. FIG.6 and FIG.7 show examples of this structure.

A semiconductor device 30 shown in FIG.6 comprises a PGA-type package 31 having a cavity-down structure; a semiconductor chip 32 mounted on the package 31; and the heat radiation fin 10 mounted on the backside (i.e., the upper side in FIG.6) of the semiconductor chip 32. However, the heat radiation fin 10 shown in FIG.6 comprises seven heat radiation plates 12 formed on the substrate 11, unlike the five plates of the heat radiation fin 10 shown in FIG.2.

The package 31 comprises: a multilayer interconnection structure having a cavity formed in the middle part; a metal plate 33 formed on one surface of the multilayer interconnection structure to be used as a heat radiation plate or a reinforcing plate; and pins 34 formed in a grid on the other surface of the multilayer interconnection structure to be used as external connection terminals. The pins (external connection terminals) 34 are used to mount the semiconductor device 30 on a mounting substrate such as a motherboard.

The semiconductor chip 32 is placed in the cavity formed in the middle part of the package 31. A back surface (an opposite surface to a surface on which an electrode terminal of the semiconductor chip 32 is formed) of the semiconductor chip 32 is bonded to the metal plate 33. Further on the metal plate 33 is mounted the heat radiation fin 10. The electrode terminal of the semiconductor chip 32 is electrically connected to an interconnection pattern formed in each of interconnection layers of the package 31 through a bonding wire 35. A sealing resin 36 covers and seals the semiconductor chip 32 and the bonding wire 35.

It should be noted that, when the back surface (the opposite surface to the surface on which the electrode terminal of the semiconductor chip 32 is formed) of the semiconductor chip 32 is exposed, the heat radiation fin 10 may be mounted directly on the back surface.

A semiconductor device 40 shown in FIG.7 comprises a BGA-type package 41 using a TAB technology; a semiconductor chip 42 mounted on the package 41; and the heat radiation fin 10 mounted on the backside (i.e., the upper side in FIG.7) of the semiconductor chip 42. As with the heat radiation fin 10 shown in FIG.6, the heat radiation fin 10 shown in FIG.7 comprises seven heat radiation plates 12 formed on the substrate 11.

The package 41 comprises: a metal plate 43 used as a heat radiation plate or a reinforcing plate on which the heat radiation fin 10 is mounted; a fixing plate 44 supporting the entire package 41; an adhesive 45a bonding a back surface (an opposite surface to a surface on which an electrode terminal 42a is formed) of the semiconductor chip 42 to the metal plate 43; an adhesive 45b bonding the fixing plate 44 to the metal plate 43; a TAB tape 46 (formed of a polyimide resin film and a copper (Cu) foil patterned on both surfaces thereof) used as an interconnection substrate; and an adhesive 47 bonding the TAB tape 46 to the fixing plate 44.

It should be noted that, when the back surface (the opposite surface to the surface on which the electrode terminal 42a is formed) of the semiconductor chip 42 is exposed, the heat radiation fin 10 may be mounted directly on the back surface.

The semiconductor chip 42 is mounted on the package 41 by flip chip bonding so that the electrode terminal 42a thereof is electrically connected to a wiring pattern of the TAB tape 46. An underfill agent 48 fills a gap between the semiconductor chip 42 and the TAB tape 46. A solder bump (external connection terminal) 49 is electrically connected to the electrode terminal 42a of the semiconductor chip 42 via a through hole formed at a predetermined position of the TAB tap 46.

The present invention is not limited to the specifically disclosed embodiments, and variations and modifications may be made without departing from the scope of the present invention.

The present application is based on Japanese priority application No.2000-021914 filed on January 31, 2000, the entire contents of which are hereby incorporated by reference.

## Claims

1. A heat radiation fin (10) comprising:
a substrate (11) having a high thermal conductivity; and
a plurality of heat radiation plates (12),
characterized in that:
said plurality of said heat radiation plates (12) are arranged upright on said substrate (11) with predetermined intervals therebetween; and
each of said heat radiation plates (12) is formed of a heat-resistant resin containing carbon fibers.

2. The heat radiation fin (10) as claimed in claim 1, characterized in that said carbon fibers are woven so that the carbon fibers extend in a plurality of directions parallel to a surface of each of said heat radiation plates (12).

3. The heat radiation fin (10) as claimed in claim 1, characterized in that said carbon fibers are woven so that the carbon fibers extend in a plurality of directions parallel to a surface of each of said heat radiation plates (12) and perpendicular to a surface of said substrate (11).

4. The heat radiation fin (10) as claimed in claim 1, characterized in that said substrate (11) is formed of a heat-resistant resin containing carbon fibers.

5. The heat radiation fin (10) as claimed in claim 1, characterized in that said substrate (11) is a metal plate formed of one of copper and aluminum.

6. The heat radiation fin (10) as claimed in claim 1, characterized in that said heat radiation plates (12) are arranged upright in an array so that surfaces of said heat radiation plates oppose each other.

7. The heat radiation fin (10) as claimed in claim 1, characterized in that at least one of said heat radiation plates (12) has an opening (12b) formed therein.

8. A manufacturing method of a heat radiation fin (10), characterized by the steps of:
preparing a plurality of heat-resistant resin members (12a) each having a rectangular shape and a predetermined size in a form of a prepreg containing carbon fibers;
arranging said heat-resistant resin members (12a) with predetermined intervals therebetween and bending a portion of each of said heat-resistant resin members so that each of said heat-resistant resin members has a shorter portion and a longer portion forming an L-shape; and
placing a substrate (11a) having a high thermal conductivity on said shorter portion and bonding said shorter portion to said substrate by heating and pressurizing.

9. A manufacturing method of a heat radiation fin (10), characterized by the steps of:
preparing a plurality of heat-resistant resin members (12a) each having a rectangular shape and a predetermined size in a form of a prepreg containing carbon fibers;
molding each of said heat-resistant resin members (12a) by heating and pressurizing so that each of said heat-resistant resin members has a shorter portion and a longer portion forming an L-shape; and
placing each of said heat-resistant resin members (12) on a substrate (11a) having a high thermal conductivity with predetermined intervals therebetween so that said shorter portion faces said substrate, and bonding said shorter portion to said substrate by heating and pressurizing.

10. A manufacturing method of a heat radiation fin (10), characterized by the steps of:
preparing a plurality of heat-resistant resin members (12a) each having a rectangular shape and a predetermined size in a form of a prepreg containing carbon fibers;
molding each of said heat-resistant resin members (12a); and
placing each of said heat-resistant resin members (12) on a substrate (11a) having a high thermal conductivity with predetermined intervals therebetween by thrusting a portion of each of said heat-resistant resin members into said substrate, and bonding each of said heat-resistant resin members to said substrate by heating and pressurizing.

11. A semiconductor device (40) comprising:
a semiconductor element (42); and
a heat radiation fin (10) provided on a side opposite to a surface of said semiconductor element (42) on which an electrode terminal (42a) is formed,
wherein said heat radiation fin (10) comprises:
a substrate (11) having a high thermal conductivity; and
a plurality of heat radiation plates (12),
characterized in that:
said plurality of said heat radiation plates (12) are arranged upright on said substrate with predetermined intervals therebetween; and
each of said heat radiation plates (12) is formed of a heat-resistant resin containing carbon fibers.
